# EUROPÄISCHE PATENTSCHRIFT

(11) **EP 3 066 904 B1**
(45) Veröffentlichungstag und Bekanntmachung des Hinweises auf die Patenterteilung: **11.07.2018**
(21) Anmeldenummer: 14796737.6
(22) Anmeldetag: 03.11.2014
(51) Int. Cl.: H05K 7/14

(54) **FUNKTIONSKOMPONENTE FÜR EIN KOMPONENTENAUFBAUSYSTEM**
FUNCTIONAL COMPONENT FOR A COMPONENT CONSTRUCTION SYSTEM
COMPOSANT FONCTIONNEL POUR UN SYSTÈME D'ASSEMBLAGE DE COMPOSANTS

(30) Priorität: 04.11.2013 DE 102013112117
(43) Veröffentlichungstag der Anmeldung: 14.09.2016
(73) Patentinhaber: Phoenix Contact GmbH & Co. KG, 32825 Blomberg (DE)
(72) Erfinder: BURY, Joachim, 31812 Bad Pyrmont (DE); SALOMON, Thomas, 33415 Verl (DE)
(74) Vertreter: Patentship Patentanwaltsgesellschaft mbH
(86) Internationale Anmeldenummer: PCT/EP2014/073560
(87) Internationale Veröffentlichungsnummer: WO 2015/063294

(56) Entgegenhaltungen:
- EP-A1- 1 901 598
- EP-A1- 2 157 845
- US-A- 5 768 091
- US-A1- 2005 231 931

## Beschreibung

Die vorliegende Erfindung betrifft eine Funktionskomponente für ein Komponentenaufbausystem zum elektrischen Verbinden mit einem Brückenmodul eines Komponentenaufbausystems.

Moderne Komponentenaufbausysteme der Automatisierungstechnik bestehen typischerweise aus einer Vielzahl von Funktionskomponenten, die in einem Schaltschrank angeordnet sind. Die Verteilerfunktionen für Energie und Daten sind mit getrennten Stecksystemen realisiert. Ein schaltschrankloser Aufbau ist nicht möglich, da Peripheriegeräte nahe dem Schaltschrank mit einer sternförmigen Energieverteilung hängen. Werden Feldbuskonzepte verwendet, bei denen einzelne Komponenten auf Rückplatten aufgesetzt werden, werden auf die Rückplatten hohe Gewichtskräfte ausgeübt.

Die Druckschrift DE 30 30 906 A1 betrifft einen Umschalt-Brückenstecker. Der Umschalt-Brückenstecker umfasst zwei jeweils zwei Steckerstifte aufweisende Leitungsbrücken, die im Abstand der Steckerstifte paarweise jeweils parallel zueinander in einem gemeinsamen Steckerteil aus Isoliermaterial für Leiterbahnen auf einer Leiterplatte gehalten sind.

In der EP 1 901 598 A1 ist ein modulares Automatisierungsgerät mit fünf Baugruppen offenbart. Jede der Baugruppen ist mit einem im Wesentlichen U-förmigen Baugruppen-Busmodulteil versehen, welches mit einer Leiterplatte elektrisch verbunden ist und mit einem dazu im Wesentlichen symmetrisch aufgebauten U-förmigen Verbindungs-Busmodulteil bei zusammengebautem Automatisierungsgerät elektrisch und mechanisch in Wirkverbindung steht. Es ist die der Erfindung zugrundeliegende Aufgabe, eine Funktionskomponente für ein einfacher zu montierendes Komponentenaufbausystem anzugeben.

Diese Aufgabe wird durch den Gegenstand mit den Merkmalen nach dem unabhängigen Anspruch gelöst. Vorteilhafte Ausführungsformen der Erfindung sind Gegenstand der Figuren, der Beschreibung und der abhängigen Ansprüche.

Gemäß einem Aspekt der Erfindung wird die Aufgabe durch eine Funktionskomponente für ein Komponentenaufbausystem zum elektrischen Verbinden mit einem Brückenmodul gelöst, die ein Gehäuse mit einer Komponentenbefestigungseinrichtung zum Befestigen der Funktionskomponente an einer Tragprofilschiene umfasst. Dadurch wird beispielsweise der technische Vorteil erreicht, dass die Montage der Funktionskomponente beschleunigt und vereinfacht wird.

Das Komponentenaufbausystem kann beispielsweise ein Feldbussystem sein.

In einer vorteilhaften Ausführungsform ist das Gehäuse aus einem Funktionsgehäuseunterteil und einem Funktionsgehäuseoberteil zusammengesetzt. Dadurch wird beispielsweise der technische Vorteil erreicht, dass die Funktionskomponente modular aus unterschiedlichen Grundkomponenten zusammensetzbar ist, um so je nach verwendetem Funktionsgehäuseoberteil eine unterschiedliche Funktionalität zu erreichen.

In einer weiteren vorteilhaften Ausführungsform ist zwischen dem Funktionsgehäuseunterteil und dem Funktionsgehäuseoberteil ein umlaufender Dichtring angeordnet. Dadurch wird beispielsweise der technische Vorteil erreicht, dass ein Eindringen von Feuchtigkeit verhindert wird.

In einer weiteren vorteilhaften Ausführungsform umfasst das Funktionsgehäuseoberteil einen Frequenzumrichter und/oder ein Netzteil und/oder ein Netzteil.

In einer weiteren vorteilhaften Ausführungsform umfasst das Gehäuse zumindest eine Aussparung zum Einsetzen eines elektrischen Steckabschnitts eines Brückenmoduls. Dadurch wird beispielsweise der technische Vorteil erreicht, dass eine zuverlässige elektrische und mechanische Verbindung zwischen dem Brückenmodul und der Funktionskomponente hergestellt wird.

In einer weiteren vorteilhaften Ausführungsform umfasst die Funktionskomponente eine erste Aussparung zum Einsetzen eines ersten elektrischen Steckabschnitts und eine zweite Aussparung zum Einsetzen eines zweiten elektrischen Steckabschnitts. Dadurch wird beispielsweise der technische Vorteil erreicht, dass je ein Brückenmodul an einer von zwei Seiten der Funktionskomponente aufsetzbar ist.

In einer weiteren vorteilhaften Ausführungsform umfasst die Funktionskomponente einen Einsatzabschnitt zum Einsetzen in eine Aufnahmenut des Brückenmoduls, um Zugkräfte der Funktionskomponente entlang der Tragprofilschiene aufzunehmen. Dadurch wird beispielsweise der technische Vorteil erreicht, dass eine Beschädigung der Steckkontakte durch Zugkräfte verhindert wird.

In einer weiteren vorteilhaften Ausführungsform umfasst die Funktionskomponente einen ersten Einsatzabschnitt an einer ersten Gehäuseseite und einen zweiten Einsatzabschnitt an einer gegenüberliegenden Gehäuseseite. Dadurch wird beispielsweise der technische Vorteil erreicht, dass die Zugkräfte der Funktionskomponente effizient und drehmomentfrei an zwei Seiten auf das Brückenmodul übertragen werden können.

In einer weiteren vorteilhaften Ausführungsform umfasst die Funktionskomponente eine erste Komponentenbefestigungseinrichtung für ein erstes Tragprofil der Tragprofilschiene und eine zweite Komponentenbefestigungseinrichtung für ein zweites Tragprofil der Tragprofilschiene. Dadurch wird beispielsweise der technische Vorteil erreicht, dass die Funktionskomponente zweiseitig an der Tragprofilschiene befestigt werden kann.

In einer weiteren vorteilhaften Ausführungsform weist die Komponentenbefestigungseinrichtung einen verschiebbaren Rastschieber zum Untergreifen der Tragprofilschiene auf. Dadurch wird beispielsweise der technische Vorteil erreicht, dass die Funktionskomponente stabil und auf einfache Weise befestigt werden kann.

In einer weiteren vorteilhaften Ausführungsform ist der Rastschieber an der Funktionskomponente zwischen einer vorgeschobenen Arretierungsstellung zum Untergreifen der Funktionskomponente auf der Tragprofilschiene und einer zurückgezogenen Freigabestellung zum Aufsetzen der Funktionskomponente auf die Tragprofilschiene verschiebbar. Dadurch wird beispielsweise der technische Vorteil erreicht, dass sich der Rastschieber zwischen zwei Stellungen verschieben lässt und eine einfache Handhabung erreicht wird.

In einer weiteren vorteilhaften Ausführungsform umfasst der Rastschieber eine Druckfeder zum Unterstützen der Bewegung des Rastschiebers in die vorgeschobene Arretierungsstellung, durch die sich vom Rastschieber gegen eine Gehäusewand der Funktionskomponente abstützt. Dadurch wird beispielsweise der technische Vorteil erreicht, dass eine Arretierung des Rastschiebers erleichtert wird.

In einer weiteren vorteilhaften Ausführungsform umfasst der Rastschieber einen Rastarm zum Einrasten des Rastschiebers in der Arretierungsstellung und zum Einrasten des Rastschiebers in der Freigabestellung. Dadurch wird beispielsweise der technische Vorteil erreicht, dass ein unbeabsichtigtes Lösen aus der Arretierungsstellung oder der Freigabestellung verhindert wird.

In einer weiteren vorteilhaften Ausführungsform umfasst der Rastschieber einen Fixierfederarm zum Fixieren des Rastschiebers in der Freigabestellung. Dadurch wird beispielsweise der technische Vorteil erreicht, dass der Rastarm sich nicht unbeabsichtigt in die Arretierungsstellung bewegen kann.

In einer weiteren vorteilhaften Ausführungsform umfasst der Fixierfederarm ein Druckelement zum Drücken des Fixierfederarms in eine Lösestellung, in der der Rastschieber in die Arretierungsstellung verschiebbar ist. Dadurch wird beispielsweise der technische Vorteil erreicht, dass der Rastarm auf einfache Weise in die Lösestellung bewegt werden kann.

In einer weiteren vorteilhaften Ausführungsform umfasst der Rastschieber eine Öffnung zum Einsetzen eines Werkzeugs, um den Rastschieber zu verschieben. Dadurch wird beispielsweise der technische Vorteil erreicht, dass der Rastschieber mit größerem Krafteinsatz verschoben werden kann.

In einer weiteren vorteilhaften Ausführungsform umfasst die Funktionskomponente einen Kühlkörper zum Ableiten von Wärme.

Ausführungsbeispiele der Erfindung sind in den Zeichnungen dargestellt und werden im Folgenden näher beschrieben.

Es zeigen:
- Fig. 1: unterschiedliche Ansichten eines Komponentenaufbausystems;
- Fig. 2: unterschiedliche Ansichten der Feldbuskomponente mit einem Einsetzabschnitt;
- Fig. 3: eine Explosionsansicht eines Funktionsgehäuseunterteils;
- Fig. 4: mehrere Querschnittsansichten durch eine Komponentenbefestigungseinrichtung;
- Fig. 5: zwei Ansichten eines Funktionsgehäuseunterteils einer weiteren Funktionskomponente; und
- Fig. 6: eine Ansicht eines Funktionsgehäuseoberteils.

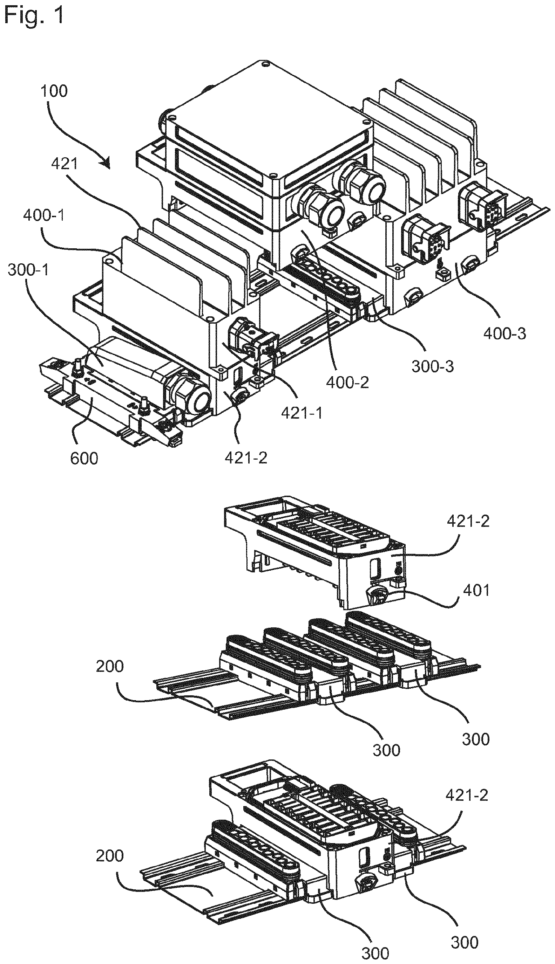

Fig. 1 zeigt eine Querschnittsansicht eines Komponentenaufbausystems 100. Das Komponentenaufbausystem 100 ist aus einem zusammensteckbaren Gehäusebaukasten zusammengesetzt, bei dem die Funktionskomponenten 400-1, 400-2 und 400-3 auf eine Tragprofilschiene 200 aufgerastet werden. Das Aufbaukonzept des Komponentenaufbausystems 100 umfasst eine Tragprofilschiene 200 als Montageplattform, die Brückenmodule 300-1 und 300-3 und die Funktionskomponenten 400, die jeweils aus einem Gehäuse 421 mit einem Funktionsgehäuseunterteil 421-2 als Verbindungsunterteil und einem Funktionsgehäuseoberteil 421-1 als Funktionsoberteil bestehen.

Je nach Anwendungszweck können unterschiedliche Ausführungen des Aufbaukonzeptes realisiert werden. Das Aufbaukonzept ist endlos erweiterbar. Die internen elektrischen Verbindungen für Energieverteilung von beispielsweise 400V oder 24V und der Datenbus werden gleichzeitig mit dem Zusammenstecken der Komponenten realisiert. Die Verbindungsfunktionen werden im Funktionsgehäuseunterteil 421-2 der Funktionskomponenten 400-1 bis 400-3 und den Brückenmodulen 300-1 und 300-2 realisiert. Die Funktionen Versorgen, Schützen, Schalten ergeben sich aus der Reihenfolge der Anordnung der Funktionskomponenten 400-1 bis 400-3. Die Anwenderfunktionen, wie beispielsweise Versorgen, Schützen oder Schalten, sind im Funktionsgehäuseoberteil 421-1 realisiert, das über Steckkontakte mit dem Funktionsgehäuseunterteil 421-2 verbunden ist.

Das Funktionsgehäuseoberteil 421-1 hat eine definierte mechanische und elektrische Schnittstelle zum Funktionsgehäuseunterteil 421-2 und kann auch auf anderen Funktionsgehäuseunterteilen 421-2 mit gleicher Schnittstelle verwendet werden. Das Funktionsgehäuseunterteil 421-2 enthält lediglich die Verbindungstechnik. Das Funktionsgehäuseoberteil 421-1 enthält beispielsweise die Funktionen Trennen, Schützen oder Schalten. Die Wirkungsrichtung der vorgenannten Funktionen erfolgt je nach Funktionsgehäuseoberteil 421-1 und Funktionsgehäuseunterteil 421-2 in der Linie und/oder in den Verbraucherabgang, d.h. einer Steckverbindung in dem Funktionsgehäuseoberteil 421-1. Die Verbindungstechnik kann im Funktionsgehäuseunterteil 421-2 unterbrochen sein.

Die Tragprofilschiene 200 bildet ein einteiliges Trägersystem mit einer breiten Schiene für einen Rack-Aufbau, die die Geometrie der Auflagekanten des Brückenmoduls 300-1 und 300-3 und der Funktionskomponenten 400-1 bis 400-3 nachbildet. Alternativ können zwei getrennte Standard-Tragprofilschienen als zweiteiliges Trägersystem, beispielsweise mit einer Breite von 35 mm, für einen Wandaufbau verwendet werden. Das Tragprofil kann durch ein Hutprofil gebildet werden. Die Funktionskomponenten 400-1 bis 400-3 sind seitlich an einem Festlager-Erdungsmodul 600 befestigt.

Die Brückenmodule 300 können in unterschiedlichen Breiten ausgeführt sein, so dass der Abstand zwischen gefügten Funktionskomponenten 400-2 und 400-3 durch das Brückenmodul 300-3 bestimmt wird. Dieser Abstand definiert einen Lüftungskamin zwischen den Funktionskomponenten 400, die beispielsweise ein metallisches Funktionsgehäuseoberteil 421-1 als Kühlkörper umfassen. Der entstehende Luftkanal dient zur seitlichen Entwärmung der Funktionskomponenten 400. Zudem kann ein Freiraum zwischen den Funktionskomponenten 400 für eine senkrecht durchgeführte Verkabelung im unteren Gehäusebereich verwendet werden, da sich dort kein Kühlkörper befindet. Die Brückenmodule werden mittels einer Modulrasteinrichtung 301 an der Tragprofilschiene 200 befestigt.

Das Festlager-Erdungsmodul 600 setzt das Gesamtsystem in x-Richtung an einem Fixpunkt auf der Tragprofilschiene 200 fest. Durch diese Anordnung ist, von einem Fixpunkt aus, ein freies Atmen des Systemaufbaues in x-Richtung möglich, wie beispielsweise bei wärmebedingtem Längenwachstum. Die mechanische Klemmung dieses Fixpunktes ist zugleich die zentrale elektrische Erdung und Verbindung mit der Tragprofilschiene des Systemaufbaus.

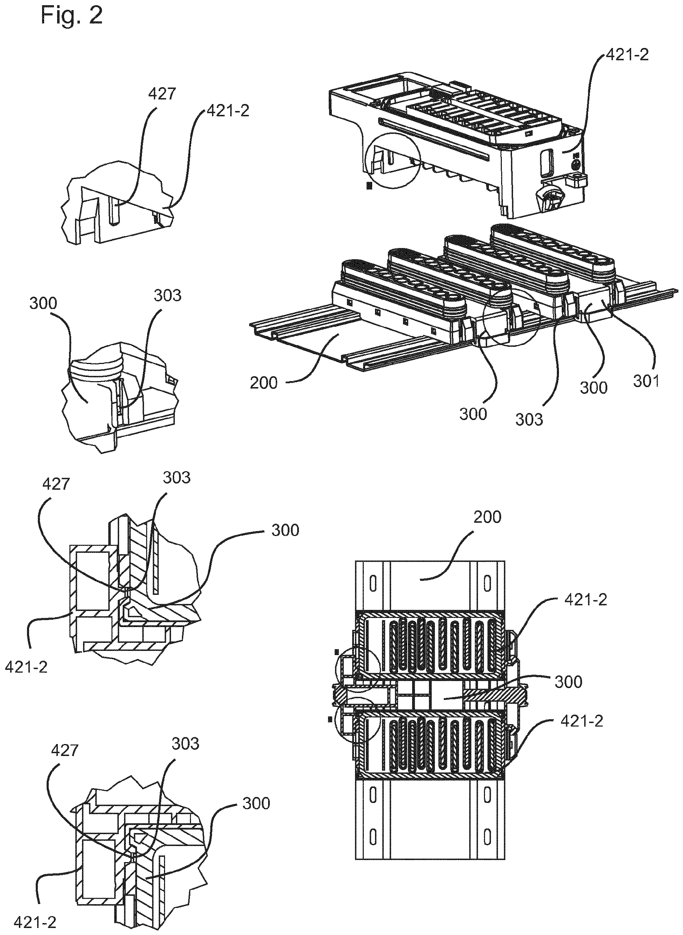

Fig. 2 zeigt unterschiedliche Ansichten des Funktionsgehäuseunterteils 421-1. An den Querseiten umfasst das Brückenmodul 300 jeweils zwei Aufnahmenuten 303 zum Einsetzen eines Einsatzabschnittes 427 einer rechtseitigen oder linksseiteigen Funktionskomponente 400, um Zugkräfte der Funktionskomponente 400 entlang der Tragprofilschiene 200 aufzunehmen. Durch den Einsatzabschnitt 427 des Funktionsgehäuseunterteils 421-1 der Funktionskomponente 400 und die Aufnahmenut 303 wird eine formschlüssige Verbindung zwischen der Funktionskomponente 400 und dem Brückenmodul 300 hergestellt. Dadurch kann eine Beschädigung der Steckabschnitte 321 durch Zugkräfte verhindert werden. Der Einsatzabschnitt 427 ragt stegartig aus dem Gehäuse 421 heraus, so dass dieser beim Aufsetzen der Funktionskomponente 400 in die Aufnahmenut 303 gleitet.

Zur mechanischen Entkopplung der schwimmend gelagerten elektrischen Steckverbindungen der Brückenmodule 300 und der Funktionskomponenten 400 findet eine übergeordnete mechanische Vorzentrierung statt. Dies geschieht durch das mechanische Eingreifen des in der Funktionskomponente 400 angeordneten rippenförmigen Steckabschnitts 321, der in die entsprechende Aufnahmenut 303 im Brückenmodul 300 eingreift und in der Endlage in x- und y-Richtung jeweils anliegend ist.

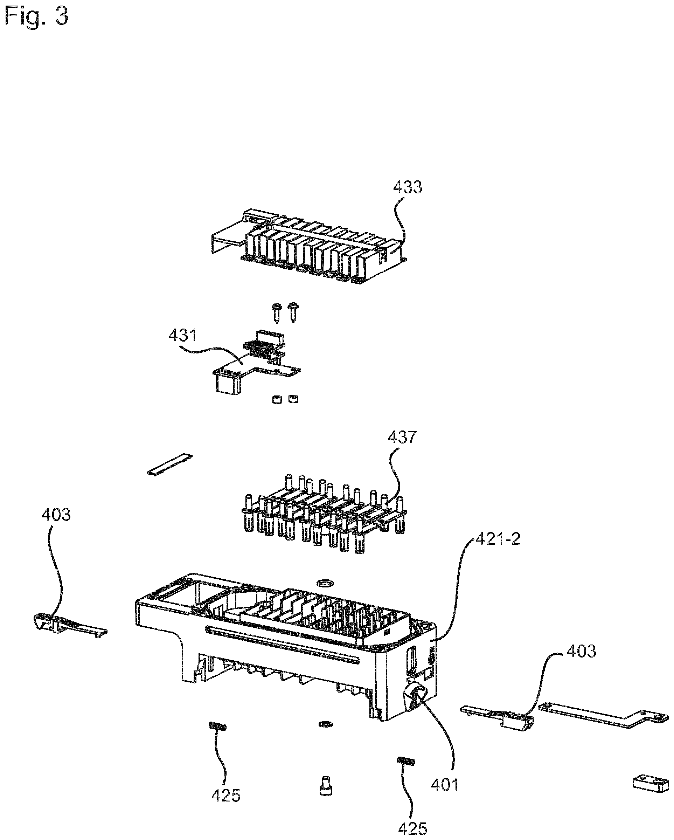

Fig. 3 zeigt eine Explosionsansicht eines Funktionsgehäuseunterteils 421-2. Das Funktionsgehäuseunterteil 421-2 umfasst zwei Komponentenbefestigungseinrichtungen 401 zum Befestigen der Funktionskomponente 400 an der Tragprofilschiene 200. Die Komponentenbefestigungseinrichtungen 401 umfassen jeweils einen Rastschieber zum Arretieren des Funktionsgehäuseunterteils 421-1 an der Tragprofilschiene. Im Inneren des Funktionsgehäuseunterteils 421-1 sind mehrere elektrische Verbinder 437 und ein Datenbusstecker 431 angeordnet. Der Datenbusstecker 431 und die elektrischen Verbinder 437 werden von einem Aufsatz 433 abgedeckt.

Der Rastschieber 403 umfasst eine Druckfeder 425 zum Unterstützen der Bewegung des Rastschiebers 403 in die vorgeschobene Arretierungsstellung, durch die sich vom Rastschieber 403 gegen eine Gehäusewand der Funktionskomponente 400 abstützt. Durch die Druckfeder 425 wird der Rastschieber in die vorgeschobenen Arretierungsstellung gedrückt. Die Druckfeder 425 ist zwischen einer Anschlagsfläche des Rastschiebers 403 und einer Anschlagsfläche des Funktionsgehäuseunterteils 421-2 angeordnet.

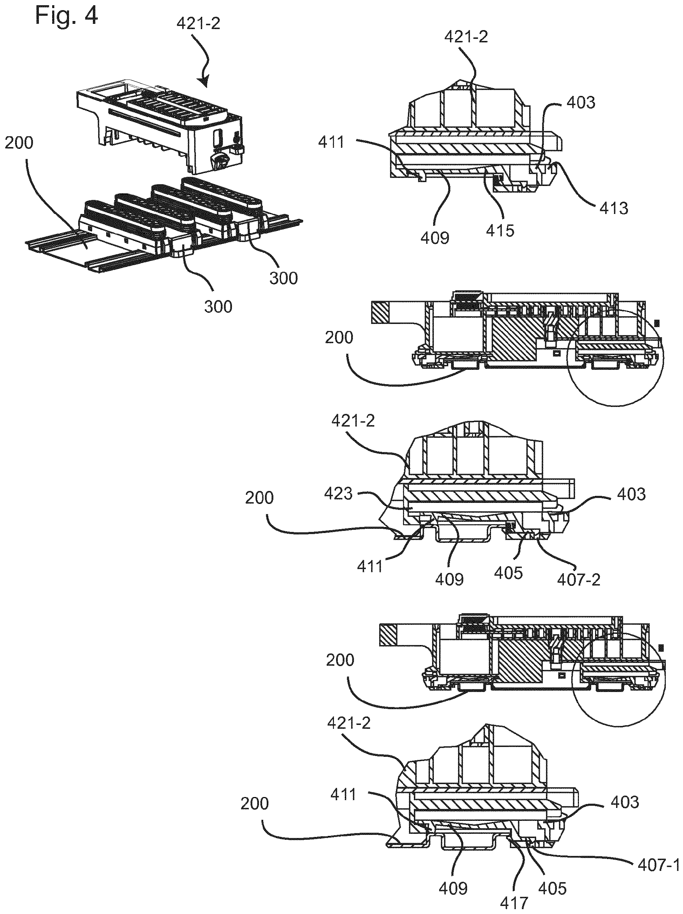

Fig. 4 zeigt mehrere Querschnittsansichten durch die Komponentenbefestigungseinrichtung 401 an dem Funktionsgehäuseunterteil 421-2. Der Rastschieber 403 ist an der Funktionskomponente 400 verschiebbar angeordnet und kann zwischen einer Arretierungsstellung zum Arretieren der Funktionskomponente 400 auf der Tragprofilschiene 200 und einer Freigabestellung zum Aufsetzen oder Entnehmen der Funktionskomponente 400 auf die Tragprofilschiene 200 bewegt werden. In der Arretierungsstellung hintergreift eine Befestigungsnase 417 die Tragprofilschiene 200, so das ein Formschluss entsteht. In der Freigabestellung ist die Befestigungsnase 417 zurückgezogen.

Der Rastschieber 403 umfasst einen federnden Rastarm 405, der je nach Stellung in eine erste Rastöffnung 407-1 oder eine zweite Rastöffnung 407-2 eingreift. Dadurch kann die Arretierungsstellung oder die Freigabestellung rastend aufrechterhalten werden. Ist der Rastarm 405 in der ersten Rastöffnung 407-1 angeordnet, befindet sich der Rastschieber 403 in der Arretierungsstellung. Ist der Rastarm 405 in der zweiten Rastöffnung 407-2 angeordnet, befindet sich der Rastschieber 403 in der Freigabestellung.

Der Rastschieber 403 umfasst zudem einen Fixierfederarm 409 zum Fixieren des Rastschiebers 403 in der Freigabestellung, so dass der Rastschieber 403 solange in der Freigabestellung gehalten wird, bis der Fixierarm 409 nach oben gedrückt wird. Zu diesem Zweck schlägt der Fixierfederarm 409 des Rastschiebers 403 im Inneren der Komponentenbefestigungseinrichtung 401 an einem Anschlag 419 an und sperrt dadurch die Bewegung des Rastschiebers 403. Der Anschlag 419 verhindert ein Verschieben des Rastschiebers 403 in Richtung der Arretierungsstellung.

Wird die Funktionskomponente 400 auf die Rastschiene 200 gesetzt, wird der Fixierfederarm 409 durch ein Druckelement 411 nach oben gedrückt, so dass der Fixierfederarm 409 in eine Lösestellung gedrückt wird, in der der Fixierfederarm 409 beim Verschieben des Rastschiebers 403 in die Ausnehmung 423 eindringen kann. In dieser Lösestellung ist der Rastschieber 403 von der Freigabestellung in die Arretierungsstellung verschiebbar und rastet anschließend in der Rastöffnung 407-1 ein. Das Druckelement 411 wird beim Aufsetzen der Funktionskomponente 400 auf die Tragprofilschiene 200 betätigt, so dass die Arretierung durch den Rastschieber 403 nur bei aufgesetzter Funktionskomponente 400 erfolgen kann. Wird das Druckelement 411 nicht von der Tragprofilschiene 200 betätigt schlägt der Fixierfederarm 409 an dem Gehäuse an, so dass eine Verschiebung des Rastschiebers 405 gesperrt ist.

Zur Verstärkung der Wirkung und Stabilität des Fixierfederarms 409 ist ein Unterstützungsabschnitt 415 vorgesehen, der sich im Lauf des Fixierfederarms 409 nach außen hin verbreitert. Daneben umfasst der Rastschieber 403 eine Öffnung 413 zum Einsetzen eines Werkzeugs, um den Rastschieber 403 zu verschieben, wie beispielsweise eine Schraubenzieher. Der seitlich herausziehbare Rastschieber 403 ist beispielsweise als einstückiges Kunststoffteil gebildet.

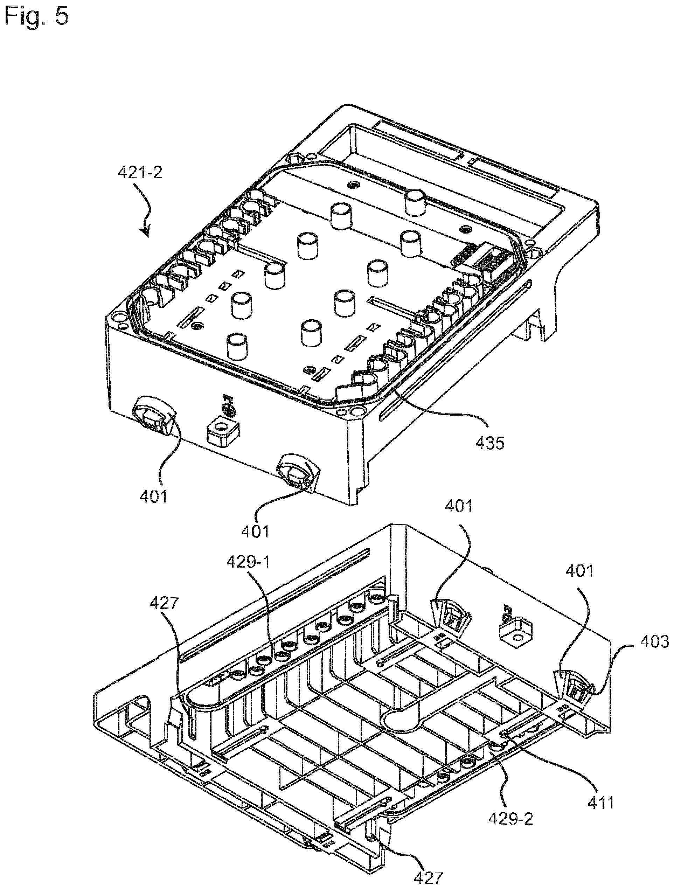

Fig. 5 zeigt zwei Ansichten eines Funktionsgehäuseunterteils 421-2 einer weiteren Funktionskomponente 400. Das Funktionsgehäuseunterteil 421-2 umfasst eine umlaufende Aussparung 435 zum Einsetzen eines Dichtringes, der das Funktionsgehäuseunterteil 421-2 und das Funktionsgehäuseoberteil 421-1 gegenseitig abdichtet. An jeder Seite des Funktionsgehäuseunterteils 421-2 sind jeweils zwei Komponentenbefestigungseinrichtung 401 angeordnet, durch die das Funktionsgehäuseunterteil 421-1 an der Tragprofilschiene befestigt wird. Die Druckelemente 411 der Rastschieber 403 stehen an der Unterseite des Funktionsgehäuseunterteils 421-1 heraus, so dass diese beim Aufsetzen auf die Tragprofilschiene 200 betätigbar sind.

Weiter sind an der Unterseite des Funktionsgehäuseunterteils 421-2 zwei Aussparungen 429-1 und 429-2. In die Aussparungen 429-1 und 429-2 werden die elektrischen Steckabschnitte des Brückenmoduls 300 eingesetzt. In die Aussparung 429-1 wird der Steckabschnitt eines ersten Brückenmoduls 300 eingesetzt. In die Aussparung 429-2 wird der Steckabschnitt eines zweiten Brückenmoduls eingesetzt.

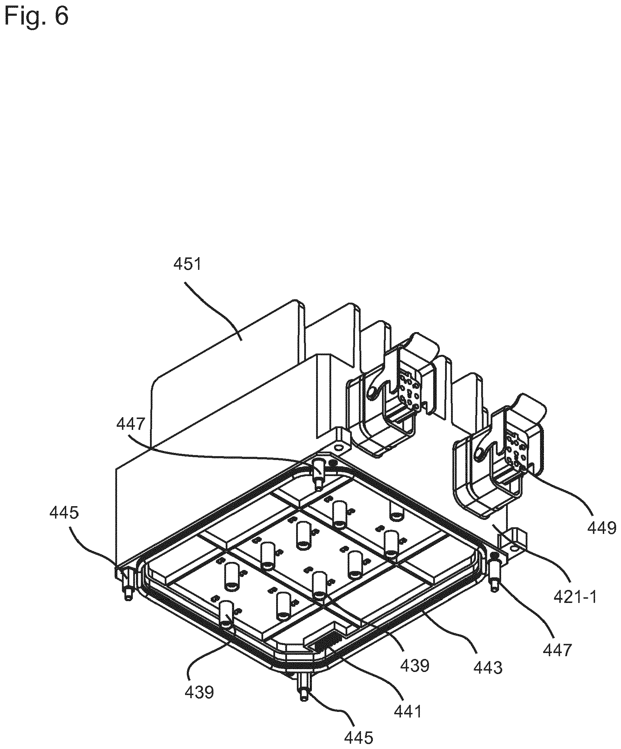

Fig. 6 zeigt eine Unteransicht des Funktionsgehäuseoberteils 421-1. An der Unterseite des Funktionskomponentenoberteils 421-1 befinden sich Steckkontakte 439 als Schnittstelle zum Herstellen einer Verbindung mit dem Funktionskomponentenoberteil 421-2. Daneben umfasst die Unterseite des Funktionskomponentenoberteils 421-1 eine Datenbusschnittstelle 441, die beim Aufsetzen des Funktionskomponentenoberteils 421-1 mit dem Funktionskomponentenoberteil 421-2 verbunden wird. Zusätzlich ist an der Unterseite des Funktionskomponentenoberteils 421-1 das Dichtelement 443 mit den Sechskantabschnitten 445 und den Zylinderabschnitten 447 aufgesetzt, die in die jeweiligen Sechskantaussparungen und Zylinderaussparungen eingesetzt werden. Seitlich an dem Funktionskomponentenoberteil 421-1 sind weitere Steckkontakte 449 zum Anschließen von Kabeln angeordnet.

Daneben kann das Funktionskomponentenoberteil 421-1 ein oder mehrere verschließbare Öffnungen zum Anschließen einer elektrischen Leitung bzw. eines Kabels, Luken, Schalterdurchbrüche für Anschlüsse, Steckbuchsen, Schalter oder einen Kühlkörper 451 mit Kühlrippen umfassen. Das Gehäuse des Funktionskomponentenoberteils 421-1 kann aus einem metallischen Material, aus Kunststoff oder Verbundwerkstoff hergestellt sein.

Das Funktionskomponentenoberteils 421-1 kann unterschiedliche Funktionen ausführen. Das Funktionskomponentenoberteil 421-1 kann aktive und passive Elemente umfassen und beispielsweise als Frequenzumrichter oder Netzteil oder zur Signalverteilung dienen. Im Funktionskomponentenoberteil 421-1 können zu diesem Zweck elektrische Eingänge und/oder Ausgänge, Steckverbindungen oder Displays angeordnet sein. Daneben kann das Funktionskomponentenoberteil 421-1 einen Kühlkörper zum Ableiten von Wärme und/oder eine Luke und/oder einen Deckel und/oder einen Schalter und/oder zumindest eine Lampe zum Anzeigen von Betriebszuständen umfassen. Ein Rasthaken kann zum Übergreifen oder Blockieren einer Funktionskomponente dienen, die unter dem Funktionskomponentenoberteil 421-1 liegt.

Die Feldstationen können durch Verwendung einer einfachen Einspeisung als Endgeräte einer klassischen Sternverteilung genutzt werden oder durch Verwendung eines Anschluss- und Verteilermoduls (AV-Modul) zu Teilnehmern oder Knoten eines Energieverteilungsnetzwerks werden. Schalt- und Schutzorgane, Motorschalter, Buskoppler, oder I/Os, usw. können in freier, funktionsbestimmter Reihenfolge links und rechts des AV-Moduls angeordnet werden. Dadurch werden Vorteile beim Engineering durch eine sichtbare Trennung von Klein- und Niederspannungskomponenten erreicht. Mehrere Feldstationen können als Teilnehmer ein Netzwerk in beliebiger Struktur, wie beispielsweise Linie, Baum oder Ring, aufspannen.

Ein zentraler Schaltschrank innerhalb des ausgelegten Leistungsbereichs der Energieverteilung ist nicht mehr erforderlich. Durch eine geeignete Ausführung des mitgeführten Datenbusses können die Reihenfolge und die Positionen einzelner Komponenten der Feldstation vor der Inbetriebnahme auf die planungsgerechte Anordnung überprüft werden (Remote Putting into Service, Remote Service).

Das Komponentenaufbausystem 100 ermöglicht einen Aufbau von 'smarten' Installationsnetzwerken für Gleichstrom und Wechselstrom und schaltschranklose Verteilungen in geeigneten Anlagenlayouts. Das Komponentenaufbausystem kann in den Anwendungsgebieten Installation oder Energieverteilung verwendet werden. Bei einer verteilten Automatisierung ist ein Aufbau von modularen Feldstationen als Funktionsknoten in 'smarten' Installationsnetzwerken möglich. In alternativen Schaltschrank-Konzepten ist ein Aufbau von modularen Stationen im Schaltschrank ohne Stromschienen und ohne Steuerverdrahtung mit identischer Projektierung für IP20 ... IP6x möglich.

Durch das Komponentenaufbausystem 100 können modulare Motorschalter im Feld mit hoher Schutzart entwickelt werden. Durch das Komponentenaufbausystem 100 wird zusätzlich ein ganzheitliches Aufbaukonzept (Power & Drive, P&D) entwickelt, das die Aufgabe einer vorteilhaften Verteilung und Bereitstellung von Energie im Feld löst, beispielsweise außerhalb eines Schaltschranks.

Die Modularität des Komponentenaufbausystems 100 ermöglicht die Ausweitung der Anwendung über die modulare Feldstation hinaus zur 'smarten' Energieverteilung bis hin zu einem alternativen Schaltschrankaufbau. Zudem kann eine Abdeckung des Spektrums von Stand-Alone-Funktionskomponenten als Endgeräte an einer klassisch sternförmigen Energieverteilung erreicht werden. Das Komponentenaufbausystem 100 ermöglicht einen flexiblen Aufbau von modularen Systemen im Feld (IP6x) und innerhalb oder außerhalb eines Schaltschranks auf Standard-Tragprofilschienen (IP20). Bei einer Vormontage kann eine Vorverdrahtung auf einem Montagegestell erfolgen.

Alle in Verbindung mit einzelnen Ausführungsformen der Erfindung erläuterten und gezeigten Merkmale können in unterschiedlicher Kombination in dem erfindungsgemäßen Gegenstand vorgesehen sein, um gleichzeitig deren vorteilhafte Wirkungen zu realisieren.

Der Schutzbereich der vorliegenden Erfindung ist durch die Ansprüche gegeben und wird durch die in der Beschreibung erläuterten oder den Figuren gezeigten Merkmale nicht beschränkt.

### BEZUGSZEICHENLISTE

- 100: Komponentenaufbausystem

- 200: Tragprofilschiene

- 300: Brückenmodul
- 301: Modulrasteinrichtung
- 303: Aufnahmenut

- 400: Funktionskomponente
- 401: Komponentenbefestigungseinrichtung
- 403: Rastschieber
- 405: Rastarm
- 407-1: Rastöffnung
- 407-2: Rastöffnung
- 409: Fixierfederarm
- 411: Druckelement
- 413: Öffnung
- 415: Unterstützungsabschnitt
- 417: Befestigungsnase
- 419: Anschlag
- 421-1: Funktionsgehäuseoberteil
- 421-2: Funktionsgehäuseunterteil
- 423: Ausnehmung
- 425: Druckfeder
- 427: Einsatzabschnitt
- 429: Aussparung
- 431: Datenbusstecker
- 433: Aufsatz
- 435: Aussparung
- 437: Elektrischer Verbinder
- 439: Steckkontakte
- 441: Datenbusschnittstelle
- 443: Dichtelement
- 445: Sechskantabschnitten
- 447: Zylinderabschnitt
- 449: Steckkontakte
- 451: Kühlkörper

## Patentansprüche

1. Funktionskomponente (400) für ein Komponentenaufbausystem (100) zum elektrischen Verbinden mit einem Brückenmodul (300), die ein Gehäuse (421) mit einer Komponentenbefestigungseinrichtung (401) zum Befestigen der Funktionskomponente (400) an einer Tragprofilschiene (200) umfasst, wobei das Gehäuse (421) zumindest eine Aussparung (429) zum Einsetzen eines elektrischen Steckabschnitts (321) eines Brückenmoduls (300) umfasst, und wobei die Funktionskomponente (400) einen Einsatzabschnitt (427) zum Einsetzen in eine Aufnahmenut (303) des Brückenmoduls (300) umfasst, um Zugkräfte der Funktionskomponente (400) entlang der Tragprofilschiene (200) aufzunehmen.

2. Funktionskomponente (400) nach Anspruch 1, wobei das Gehäuse (421) aus einem Funktionsgehäuseunterteil (421-2) und einem Funktionsgehäuseoberteil (421-1) zusammengesetzt ist.

3. Funktionskomponente (400) nach Anspruch 2, wobei zwischen dem Funktionsgehäuseunterteil (421-2) und dem Funktionsgehäuseoberteil (421-2) ein umlaufender Dichtring (335) angeordnet ist.

4. Funktionskomponente (400) nach Anspruch 2 oder 3, wobei das Funktionsgehäuseoberteil (421-1) einen Frequenzumrichter oder ein Netzteil umfasst.

5. Funktionskomponente (400) nach einem der vorangehenden Ansprüche, wobei die Funktionskomponente (400) eine erste Aussparung (429-1) zum Einsetzen eines ersten elektrischen Steckabschnitts (321-1) und eine zweite Aussparung (429-2) zum Einsetzen eines zweiten elektrischen Steckabschnitts (321-2) umfasst.

6. Funktionskomponente (400) nach Anspruch 5, wobei die Funktionskomponente (400) einen ersten Einsatzabschnitt (427) an einer ersten Gehäuseseite und einen zweiten Einsatzabschnitt (427) an einer gegenüberliegenden Gehäuseseite umfasst.

7. Funktionskomponente (400) nach einem der vorangehenden Ansprüche, wobei die Funktionskomponente (400) eine erste Komponentenbefestigungseinrichtung (401-1) für ein erstes Tragprofil der Tragprofilschiene (200) und eine zweite Komponentenbefestigungseinrichtung (401-2) für ein zweites Tragprofil der Tragprofilschiene (200) umfasst.

8. Funktionskomponente (400) nach einem der vorangehenden Ansprüche, wobei die Komponentenbefestigungseinrichtung (401) einen verschiebbaren Rastschieber (403) zum Untergreifen der Tragprofilschiene (200) aufweist.

9. Funktionskomponente (400) nach Anspruch 7, wobei der Rastschieber (403) an der Funktionskomponente (400) zwischen einer vorgeschobenen Arretierungsstellung zum Untergreifen der Funktionskomponente (400) auf der Tragprofilschiene (200) und einer zurückgezogenen Freigabestellung zum Aufsetzen der Funktionskomponente (400) auf die Tragprofilschiene (200) verschiebbar ist.

10. Funktionskomponente (400) nach Anspruch 8, wobei der Rastschieber (403) eine Druckfeder (425) zum Unterstützen der Bewegung des Rastschiebers (403) in die vorgeschobene Arretierungsstellung umfasst.

11. Funktionskomponente (400) nach Anspruch 8 oder 9, wobei der Rastschieber (403) einen Rastarm (405) zum Einrasten des Rastschiebers (403) in der Arretierungsstellung und zum Einrasten des Rastschiebers (403) in der Freigabestellung umfasst.

12. Funktionskomponente (400) nach einem der Ansprüche 8 bis 10, wobei der Rastschieber (403) einen Fixierfederarm (409) zum Fixieren des Rastschiebers (403) in der Freigabestellung umfasst.

13. Funktionskomponente (400) nach einem der vorangehenden Ansprüche, wobei die Funktionskomponente (400), insbesondere ein Funktionsgehäuseoberteil (421-2), einen Kühlkörper (451) zum Ableiten von Wärme umfasst.

## Claims

1. A functional component (400) for a component construction system (100) for electrical connection to a bridge module (300), comprising a housing (421) with a component securing device (401) for securing the functional component (400) to a support profile rail (200), wherein the housing (421) comprises at least one recess (429) for inserting an electrical plug-in section (321) of a bridge module (300), and wherein the functional component (400) comprises an insert section (427) for insertion into a receiving groove (303) of the bridge module (300) to absorb tensile forces of the functional component (400) along the support profile rail (200) .

2. The functional component (400) according to claim 1, wherein the housing (421) is composed of a functional housing lower part (421-2) and a functional housing upper part (421-1) .

3. The functional component (400) according to claim 2, wherein a peripheral sealing ring (335) is arranged between the functional housing lower part (421-2) and the functional housing upper part (421-2).

4. The functional component (400) according to claim 2 or 3, wherein the functional housing upper part (421-1) comprises a frequency inverter or a power supply unit.

5. The functional component (400) according to any one of the preceding claims, wherein the functional component (400) comprises a first recess (429-1) for inserting a first electrical plug-in section (321-1) and a second recess (429-2) for inserting a second electrical plug-in section (321-2).

6. The functional component (400) according to claim 5, wherein the functional component (400) comprises a first insert section (427) on a first housing side and a second insert section (427) on an opposite housing side.

7. The functional component (400) according to any one of the preceding claims, wherein the functional component (400) comprises a first component securing device (401-1) for a first support profile of the support profile rail (200) and a second component securing device (401-2) for a second support profile of the support profile rail (200).

8. The functional component (400) according to any one of the preceding claims, wherein the component securing device (401) comprises a slidable locking slide (403) for engaging under the support profile rail (200).

9. The functional component (400) according to claim 7, wherein the locking slide (403) is slidable on the functional component (400) between an advanced locking position for engaging under the functional component (400) on the support profile rail (200) and a retracted release position for placing the functional component (400) onto the support profile rail (200).

10. The functional component (400) according to claim 8, wherein the locking slide (403) comprises a compression spring (425) for assisting the movement of the locking slide (403) into the advanced locking position.

11. The functional component (400) according to claim 8 or 9, wherein the locking slide (403) comprises a locking arm (405) for engaging the locking slide (403) in the locking position and for engaging the locking slide (403) in the release position.

12. The functional component (400) according to any one of claims 8 to 10, wherein the locking slide (403) comprises a fixing spring arm (409) for fixing the locking slide (403) in the release position.

13. The functional component (400) according to any one of the preceding claims, wherein the functional component (400), in particular a functional housing upper part (421-2), comprises a heat sink (451) for dissipating heat.

## Revendications

1. Composant fonctionnel (400) pour un système d'assemblage de composants (100) pour la connexion électrique à un module de pont (300), qui comporte un boîtier (421) avec un dispositif de fixation de composant (401) pour la fixation du composant fonctionnel (400) sur un rail profilé support (200), dans lequel le boîtier (421) comporte au moins un évidement (429) pour l'insertion d'une section d'enfichage électrique (321) d'un module de pont (300), et dans lequel le composant fonctionnel (400) comporte une section d'insertion (427) pour l'insertion dans une rainure de réception (303) du module de pont (300) pour absorber des forces de traction du composant fonctionnel (400) le long du rail profilé support (200).

2. Composant fonctionnel (400) selon la revendication 1, dans lequel le boîtier (421) se compose d'une partie inférieure de boîtier fonctionnel (421-2) et d'une partie supérieure de boîtier fonctionnel (421-1).

3. Composant fonctionnel (400) selon la revendication 2, dans lequel une bague d'étanchéité périphérique (335) est agencée entre la partie inférieure de boîtier fonctionnel (421-2) et la partie supérieure de boîtier fonctionnel (421-2).

4. Composant fonctionnel (400) selon la revendication 2 ou 3, dans lequel la partie supérieure de boîtier fonctionnel (421-1) comporte un convertisseur de fréquence ou un bloc d'alimentation.

5. Composant fonctionnel (400) selon l'une quelconque des revendications précédentes, dans lequel le composant fonctionnel (400) comporte un premier évidement (429-1) pour l'insertion d'une première section d'enfichage électrique (321-1) et un deuxième évidement (429-2) pour l'insertion d'une deuxième section d'enfichage électrique (321-2).

6. Composant fonctionnel (400) selon la revendication 5, dans lequel le composant fonctionnel (400) comporte une première section d'insertion (427) à un premier côté de boîtier et une deuxième section d'insertion (427) à un côté de boîtier opposé.

7. Composant fonctionnel (400) selon l'une quelconque des revendications précédentes, dans lequel le composant fonctionnel (400) comporte un premier dispositif de fixation de composant (401-1) pour un premier profil support du rail profilé support (200) et un deuxième dispositif de fixation de composant (401-2) pour un deuxième profil support du rail profilé support (200).

8. Composant fonctionnel (400) selon l'une quelconque des revendications précédentes, dans lequel le dispositif de fixation de composant (401) présente un coulisseau d'encliquetage mobile (403) pour la saisie du rail profilé support (200) par dessous.

9. Composant fonctionnel (400) selon la revendication 7, dans lequel le coulisseau d'encliquetage (403) au niveau du composant fonctionnel (400) est mobile entre une position d'arrêt avancée pour la saisie par-dessous du composant fonctionnel (400) sur le rail profilé support (200) et une position de libération reculée pour la pose du composant fonctionnel (400) sur le rail profilé support (200).

10. Composant fonctionnel (400) selon la revendication 8, dans lequel le coulisseau d'encliquetage (403) comporte un ressort à pression (425) pour le soutien du mouvement du coulisseau d'encliquetage (403) dans la position d'arrêt avancée.

11. Composant fonctionnel (400) selon la revendication 8 ou 9, dans lequel le coulisseau d'encliquetage (403) comporte un bras d'encliquetage (405) pour l'encliquetage du coulisseau d'encliquetage (403) dans la position d'arrêt et pour l'encliquetage du coulisseau d'encliquetage (403) dans la position de libération.

12. Composant fonctionnel (400) selon l'une quelconque des revendications 8 à 10, dans lequel le coulisseau d'encliquetage (403) comporte un bras ressort de fixation (409) pour la fixation du coulisseau d'encliquetage (403) dans la position de libération.

13. Composant fonctionnel (400) selon l'une quelconque des revendications précédente, dans lequel le composant fonctionnel (400), en particulier une partie supérieure de boîtier fonctionnel (421-2), comporte un corps de refroidissement (451) pour l'évacuation de chaleur.
